# EUROPEAN PATENT SPECIFICATION

(11) **EP 1 008 235 B1**
(45) Date of publication and mention of the grant of the patent: **09.10.2002**
(21) Application number: 98903057.2
(22) Date of filing: 13.02.1998
(51) Int. Cl.: H03K 5/01

(54) **METHOD OF CORRECTING THE SYMBOL SHAPE ERROR OF MULTILEVEL PULSES IN BASEBAND TRANSMISSION CAUSED BY THE USE OF PULSE-RATE MODULATION**
VERFAHREN ZUM KORRIGIEREN VON SYMBOLVERZERRUNG VON MEHRPEGELPULSEN IN PULSFREQUENZMODULATIONSSYSTEMEN
PROCEDE PERMETTANT DE CORRIGER UNE ERREUR RELATIVE A LA FORME D'UN SYMBOLE D'IMPULSIONS MULTINIVEAU DANS UNE TRANSMISSION EN BANDE DE BASE, CAUSEE PAR LA RAPIDITE DE MODULATION

(30) Priority: 14.02.1997 FI 970647
(43) Date of publication of application: 14.06.2000
(73) Proprietor: Tellabs Oy, 02630 Espoo (FI)
(72) Inventor: LAAMANEN, Heikki, FIN-02230 Espoo (FI); KINNUNEN, Arto, FIN-00350 Helsinki (FI)
(74) Representative: Lipsanen, Jari Seppo Einari
(86) International application number: FI9800137
(87) International publication number: WO98036493

(56) References cited:
- GB-A- 2 253 771
- US-A- 4 977 591
- IEEE JOURNAL ON SELECTED AREAS IN COMMUNICATIONS, Volume 9, No. 6, August 1991, WALTER Y. CHEN et al., "High Bit Rate Digital Subscriber Line Echo Cancellation", pages 848-860.

## Description

The present invention relates to a method according to the preamble of claim 1 for correcting the shape error of symbols caused by the use of pulse-density modulation.

Today, fast baseband modems most frequently use pulse-amplitude modulation (PAM), whereby N databits are used to select from 2^{N} possible amplitude levels one level by which the pulse amplitude to be sent over the transmission path is multiplied. Thus, the digital information to be passed over the transmission path is represented by a pulse string of discrete amplitudes transferred over the transmission path. Examples of such arrangements are the ISDN modem defined by an ANSI standard and the HDSL modem defined by the respective ANSI and ETSI standards. In these standards, the number of possible pulse amplitudes is four, whereby each pulse carries the information of two bits. The four-level modulation scheme has been found an optimal PAM line code transmission scheme on copper subscriber connection lines.

In the text below, the conventionally employed term "symbol" is used when reference is made to a multilevel baseband pulse.

In order to improve the capacity of a transmission path, echo-cancellation techniques are conventionally employed in conjunction with bidirectional data transmission over a single cable using a single frequency band. Both of the above-mentioned modem standards utilize echo-cancellation techniques.

Echo-cancellation techniques involve documented requirements on the linearity of signal modulation which are well-known and discussed in a plurality of references (e.g., Walter Y. Chen et al., "High Bit Rate Digital Subscriber Line Echo Cancellation," IEEE Journal on Selected Areas in Communications, Vol. 9, No. 6, August 1991). Herein, the above-mentioned multiplication process of pulse amplitude with databit-dependent coefficients must be performed with a sufficiently high accuracy so that a satisfactory compliance with pulse amplitudes and shapes is attained. A typical requirement is that the energy of error components in pulse shape and amplitude is less than -65 dB relative to the pulse energy.

It is an object of the present invention to overcome the drawbacks of the above-described technique and to provide an entirely novel method for correcting signal shape error caused by the use of pulse-density modulation.

The invention is based on summing to each symbol a correction signal that reduces the error of the symbol.

More specifically, the method according to the invention is characterized by what is stated in the characterizing part of claim 1.

The invention offers significant benefits.

The invention is capable of effective correction of shape error caused by the use of pulse-density modulation.

In the following, the invention will be examined in greater detail with the help of working examples illustrated in the appended drawings in which
Figure 1 shows an example of the conventional technique of forming a four-level symbol group;
Figure 2 shows the pulses formed by summation of two pulses of those shown in Fig. 1;
Figures 3a and 3b show graphic plots of the effect of conventional techniques on the rise and fall times of the pulses;
Figures 4a and 4a show graphic plots of unfiltered spectra of pulses shown in Fig. 2;
Figure 5 shows graphic plots of filtered spectra of pulses shown in Figs. 4a and 4b;
Figure 6 shows the block diagram of an apparatus capable of realizing the method according to the invention; and
Figure 7 shows an alternative method according to the invention with the length of the correction signal extended over two symbols.

The invention discloses a method capable of improving the linearity of pulse-amplitude modulation which is accomplished by means of conventional pulse-density modulation techniques in environments having the scheme implemented in the form of a digital logic circuit in which the circuit technology is the crucial factor limiting the usable system clock frequency.

Next, the modulation of a pulse amplitude by virtue of pulse-density modulation is discussed.

The amplitude of a symbol can be shaped using a conventional method in which the symbol is accumulated from a plurality of successive short-duration pulses of identical shape. The pulses can be generated repetitively with an extremely identical shape provided that the rise and fall times of the pulses are short with respect to the pulse length.

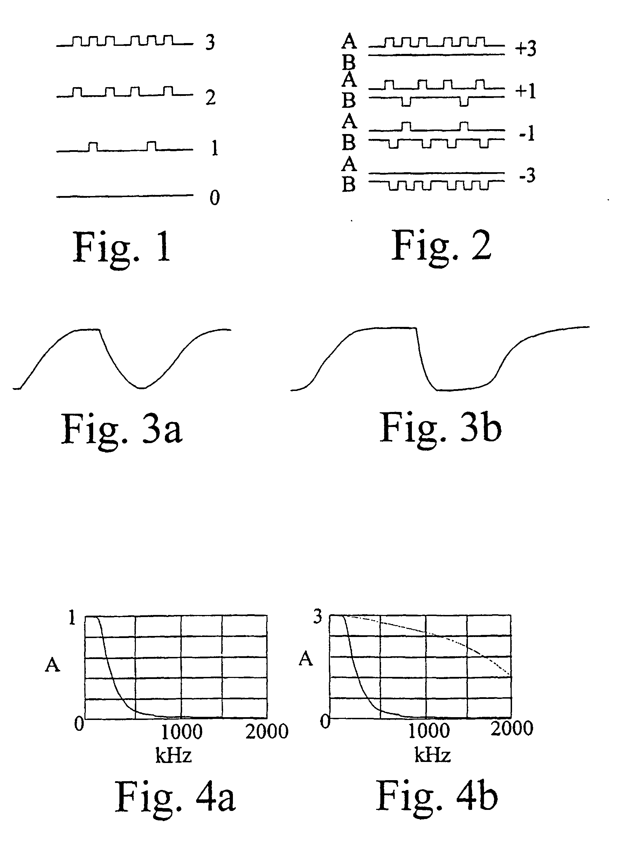

As a pulse string thus generated is passed through a low-pass filter, the result is a symbol whose amplitude is directly proportional to the number of the short-duration pulses. Now referring to Fig. 1, therein is shown an example of the generation of a four-level symbol group having target values of 0, 1, 2 and 3 assigned to the relative amplitudes. Herein, the low-pass filtering is mandatory, because the spectrum of the signal launched on a transmission path is defined in modem performance standards. In practice, the transmitted symbols are adjusted symmetrical so that, e.g., in a four-level transmission scheme, the relative amplitudes are set to -3, -1, +1 and +3. This is accomplished by summing two pulses as shown in Fig. 2.

An examination of the spectra of the pulses computed by means of a Fourier transform in the frequency plane makes it easy to see that the ratio of the symbol spectra close to the zero frequency is exactly proportional to the number of short-duration pulses. It can be readily proven that the ratio of the spectra at low frequencies is linearly proportional to the area of the pulse strings. However, at higher frequencies the ratio of symbols modulated to different levels deviates from the ideal law of proportionality. This deviation is the smaller the shorter the duration of a single elementary pulse with regard to the duration of the symbol being formed. Thus, it appears that the errors of symbols after the low-pass filtering step could under all conditions be made as small as required by using pulses of sufficiently short duration.

In practice, the concurrent circuit technology is the principal factor limiting the length of short-duration pulses because the output signal of a digital logic circuit will always have a nonzero rise and fall time. Further, the individual short-duration pulses must be generated in a repetitive manner with an exactly identical shape, whereby the overlapping of the pulses at the nonzero-duration rise and fall slopes must be avoided. This requirement is elucidated in Figs. 3a and 3b. Herein, the pulse shown in Fig. 3a has a duration which is too short with regard to the rise and fall times of the pulse, whereby overlapping of the successive pulses will occur. This condition causes detrimental nonlinear interference between the pulses. Fig. 3b shows a pulse of sufficient length with regard to its rise and fall times. Here, the pulse amplitude has under all conditions a sufficient time to settle prior to the onset of the next pulse, whereby the successive pulses will not interfere with each other and the pulse shape remains exactly constant irrespective of whether the previous or next pulse in the sequence is 0 or 1.

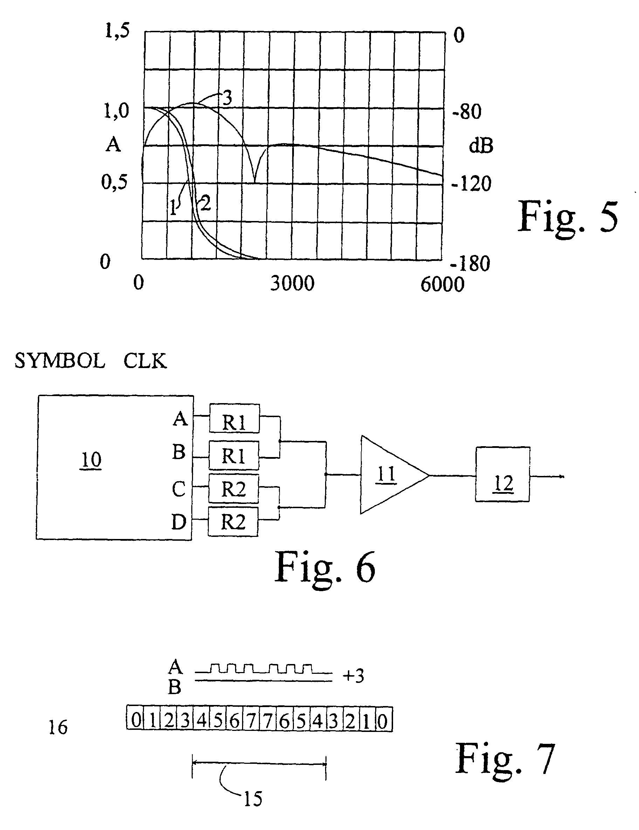

Now referring to Fig. 4a, therein are plotted the unfiltered spectra of symbol "+1" shown in Fig. 2 and symbol "+3" shown in Fig. 4b (dashed lines), as well as the transfer function (solid line) of the low-pass filter used. The spectra are so scaled as to have equal magnitudes at the zero frequency. In Fig. 5 are plotted the spectra 1 and 2 of the pulses of Fig. 4a and 4b after the low-pass filtering step. Also herein, the spectra 1 and 2 are scaled to equal magnitude at the zero frequency, whereby their shape error is easier to see. The "error" curve 3 represents the difference of the two spectra on the decibel scale. The spectra themselves are plotted on a linear scale. In the illustrated case, the energy of the error component was -36.2 dB relative to the mean energy of the pulses.

In the following is described the method according to the invention of correcting the symbol shape errors caused by the use of pulse-density modulation by virtue of correction pulses.

As discussed above, an excessive length of the short-duration pulses with regard to the length of the symbol causes in the symbol a shape error whose magnitude, observed on the frequency level, grows at higher frequencies. For instance, in the symbol group shown in Fig. 2, the mean energy of shape error components in the pulses after low-pass filtering is about -37 dB lower than the mean energy of the symbols. Owing to the low energy level of the pulse shape error, however, it is possible to improve the situation by summing the symbols with a correction signal adapted to improve the spectrum of each symbol. Pulse-density modulation offers a viable alternative for forming such correction signals and they can be summed with the symbols prior to the low-pass filtering step, whereby also the correction signal component will be subjected to low-pass filtering. Each symbol requires an individual correction signal. Thus, while the correction signal has a character related to the symbol itself, its pulse pattern is obviously different from that of the symbol. In practice, the pulse pattern of the correction signal is found with the help of a computer using a simple brute-force approximation routine. The optimization process is based on conventional integer multiplier optimization.

As the energy of shape error components is low after the low-pass filtering step, the required amplitude of the correction signal is small. Therefore, the minor error of the correction signal itself resulting from such factors as the tolerances of the resistors in the signal summation will be insignificant. This issue is elucidated by the following reasoning:

The amplitude shape error components in the symbols may be assumed to be, e.g., about -40 dB, which on an absolute signal scale is in the order of 0.01 x symbol. A further assumption can be made that the accuracy of the correction signal summation is, e.g., 4 % of the correction signal value, that is, 0.04 x correction signal. Then, the error of the summation operation with regard to the symbol amplitude is in the order of 0.01 x 0.04 = 0.0004, which corresponds to a summation error component energy level of -68 dB. Hence, the signal correction process achieves a relatively good accuracy even if the relative accuracy of the correction signal summation is not so good.

Use of a multilevel correction signal offers a better end result, because of the greater degree of freedom in shaping the spectrum of the correction signal as compared with the binary correction signal. The relative accuracy of a multilevel correction signal as compared with the correction signal itself is often inferior to that of a binary correction signal, because the multilevel steps are accomplished by means of, e.g., a resistor network, whereby the accuracy is dependent on the relative mutual accuracy of a number of individual resistors. Due to the reasons discussed above, however, such a degradation of the relative accuracy that does not exceed certain limits should not have an adverse effect.

The generation of a three-level correction signal, for instance, may be accomplished by summing a correction pulse string weighted via two resistors with the actual signal as shown in Fig. 6. Into the inputs of a pulse generating logic circuit block 10 are taken a symbol selection signal "SYMBOL" and a system clock signal "CLK". The logic circuit includes a circuitry that generates the symbol-forming signals A and B, as well as the correction signals C and D. The symbols are formed in the pulse generating logic circuit block 10 from the binary signals A and B with the help of resistors **R1**, and the correction signals are formed from the binary signals C and D with the help of resistors R2. The weighting coefficients of the correction signals can be set as desired by proper selection of the R1/R2 ratio of the resistors. The signals are amplified in an amplifier 11 and then low-pass filtered by means of a filter 12. Obviously, the arrangement of Fig. 6 illustrates one possible embodiment among the variety of signal weighting and summation methods known in the art.

In its simplest form, the correction signal has a length equal to that of the symbol itself. An improved end result will be attained by making the temporal length of the correction signal longer, because the spectrum of the correction signal is then easier to modify within the passband of the low-pass filter. Fig. 7 shows an example in which the temporal length of the correction signal 16 is twice the temporal length of two symbols 15. In this example the correction signal is formed from sixteen pulses. Owing to the symmetry of the signal, also the optimal correction signal will be symmetrical. The individual pulses of the correction signal are numbered from zero to seven in the diagram.

Also in the latter case the correction signal may be a binary signal or a multilevel signal.

The optimization of the correction signals may be carried out using, e.g., the following procedure.

As the procedure is based on integer optimization, the optimal correction signals must in practice be found with the help of a computer program. The procedure is performed as follows:
1. The transfer function of the low-pass filter is determined.
2. The weighting coefficient used in the summation of the correction signals is determined.
3. Experimental techniques (with the help of a computer) are applied to find a correction pulse string offering the optimal correction of the shape errors of the pulses in the frequency plane.
4. A test may possibly be carried out using other weighting coefficients, whereafter the procedure can be resumed from step 2.

## Claims

1. A method of correcting the shape error of a symbol caused by the use of pulse-density modulation,
**characterized in that**
- to each symbol is summed a correction signal (16) adapted to correct the error of said symbol.

2. The method defined in claim 1, **characterized in that** said correction signals (16) are formed by virtue of pulse-density modulation.

3. The method defined in claim 1, **characterized in that** said correction signals (16) are summed with said symbols prior to the low-pass filtering step.

4. The method defined in claim 1, **characterized in that** multilevel correction signals are used.

5. The method defined in claim 1, **characterized in that** said correction signals (16) have a length which is longer than that of said symbol (15).

## Patentansprüche

1. Verfahren zum Korrigieren von Symbolverzerrung bei der Verwendung von Pulsdichtemodulation, **dadurch gekennzeichnet, daß**
zu jedem Symbol ein Korrektursignal (16) summiert wird, das geeignet ist, die Verzerrung dieses Symbols zu korrigieren.

2. Verfahren nach Anspruch 1, **dadurch gekennzeichnet, daß** die Korrektursignale (16) aufgrund der Pulsdichtemodulation gebildet werden.

3. Verfahren nach Anspruch 1, **dadurch gekennzeichnet, daß** die Korrektursignale (16) vor dem Tiefpaßfilterungsschritt mit den Symbolen aufsummiert werden.

4. Verfahren nach Anspruch 1, **dadurch gekennzeichnet, daß** Mehrpegel-Korrektursignale verwendet werden.

5. Verfahren nach Anspruch 1, **dadurch gekennzeichnet, daß** die Korrektursignale (16) eine Länge haben, die länger als die des Symbols (15) ist.

## Revendications

1. Procédé de correction de l'erreur de forme d'un symbole due à l'utilisation d'une modulation de densité d'impulsions,
**caractérisé en ce que**, à chaque symbole, on ajoute un signal de correction (16) prévu pour corriger l'erreur du dit symbole.

2. Procédé selon la revendication 1, **caractérisé en ce que** les dit signaux de correction (16) sont formés par modulation de densité d'impulsions.

3. Procédé selon la revendication 1, **caractérisé en ce que** les dits signaux de correction (16) sont ajoutés aux dits symboles avant l'opération de filtrage passe-bas.

4. Procédé selon la revendication 1, **caractérisé en ce qu'**on utilise des signaux de correction à niveaux multiples.

5. Procédé selon la revendication 1, **caractérisé en ce que** les dits signaux de correction (16) ont une longueur qui est plus grande que celle du dit symbole (15).
